Europäisches Patentamt

European Patent Office

Office européen des brevets

(11) Numéro de publication: **0 0 15 173**
**B1**

(12) **FASCICULE DE BREVET EUROPEEN**

(45) Date de publication du fascicule du brevet:
14.07.82

(21) Numéro de dépôt: **80400109.7**

(22) Date de dépôt: **23.01.80**

(51) Int. Cl.³: **G 03 B 41/00**, G 05 D 3/00,
G 03 F 9/00

(54) Système optique d'alignement de deux motifs et photorépéteur utilisant un tel système.

(30) Priorité: **27.02.79 FR 7905007**

(43) Date de publication de la demande:
**03.09.80 Bulletin 80/18**

(45) Mention de la délivrance du brevet:
**14.07.82 Bulletin 82/28**

(84) Etats contractants désignés:
**CH DE GB IT NL SE**

(56) Documents cités:
**FR-A-2 062 604**
**FR-A-2 379 097**
**FR-A-2 389 928**
**US-A-3 690 881**
**US-A-3 783 520**
**US-A-3 821 545**
**US-A-4 103 998**

(73) Titulaire: **THOMSON-CSF, 173, Boulevard Haussmann,
F-75360 Paris Cedex 08 (FR)**

(72) Inventeur: **Lacombat, Michel, "THOMSON-CSF" -
SCPI 173, bld Haussmann, F-75360 Paris Cedex 08 (FR)**
Inventeur: **Dubroeucq, Georges, "THOMSON-CSF" -
SCPI 173, bld Haussmann, F-75360 Paris Cedex 08 (FR)**

(74) Mandataire: **Wang, Pierre et al, THOMSON-CSF
SCPI 173, Bld Haussmann, F-75360 Paris Cedex 08 (FR)**

BUNDESDRUCKEREI BERLIN

### Système optique d'alignement de deux motifs et photorépéteur utilisant un tel système

L'invention se rapporte à un système optique d'alignement de deux motifs et notamment à un photo-répéteur utilisant ce système optique d'alignement pour le positionnement de plaquettes semiconductrices suivant deux axes de référence.

La fabrication de circuits intégrés implique la réalisation sur le substrat de fenêtres permettant de localiser l'implantation ou le traitement. Ce substrat est recouvert d'une couche de résine photosensible. Cette réalisation de fenêtres se fait par masquage de cette résine à partir d'un masque. Antérieurement, il a été utilisé comme méthode de transfert le contact direct ou la proximité. Les procédés actuels mettent en oeuvre la technique de transfert par projection optique.

Cette projection peut être effectuée au rapport $\frac{1}{1}$ et le masque est globalement projeté sur la plaquette. Cette projection peut être également effectuée par partition de l'image soit par analyse du masque par une fente mobile, soit par l'utilisation de la technique de photo-répétition au rapport $\frac{1}{1}$.

Dans la technique de fabrication de circuit par photo-répétition directe, chaque motif est projeté directement sur la plaquette semiconductrice préalablement recouverte d'une couche de résine photo-sensible, suivant un programme préétabli, la position de la plaquette étant contrôlée par interférométrie suivant chaque direction. De manière classique, la photo-répétition est effectuée en décalant la plaquette suivant deux directions x et y orthogonales. Lors de la première exposition de la plaquette, il n'y a pas de difficultés particulières pour le positionnement, si ce n'est que les zones successivement exposées doivent être parallèles au plan du motif à projeter. Lors des expositions suivantes, au contraire, il est absolument nécessaire que les motifs projetés soient centrés et alignés par rapport aux motifs précédemment projetés, pour toutes les zones de la plaquette.

En effet, lors de la projection d'un autre motif pour réaliser un autre niveau d'intégration du circuit, la plaquette doit être mise dans la même position que lors de la première exposition, pour qu'il y ait une superposition correcte des différents motifs. Pour ce faire, il est nécessaire de centrer la plaquette et de lui faire subir une rotation qui la ramène dans sa position première. Ainsi si le second motif à projeter est exactement positionné par rapport au motif précédemment projeté, il y aura coincidence.

Dans le cas d'un transfert global, l'alignement nécessaire à la bonne superposition des images, est réalisé globalement en utilisant deux repères sur chaque plan image, diamétralement opposés pour un maximum de précision. Dans le cas de photo-répétitions directes, il est nécessaire de réaliser un alignement global pour définir la position angulaire de la plaquette et cet alignement peut être suffisant si la répartition des futures puces semi-conductrices sur la plaquette répond à une loi linéaire connue. Cependant, si on recherche un maximum de précision, un réalignement périodique, voire puce par puce peut être nécessaire.

L'invention peut s'appliquer à tous les cas de transfert par projection: global, à balayage ou photo-répétition. Cependant c'est dans ce dernier cas qu'elle présente le plus d'intérêt.

Dans l'art antérieur, la méthode la plus répandue consiste à superposer des motifs-repères portés sur le masque et sur la plaquette semiconductrice, par l'intermédiaire de l'optique de transfert et d'observer cette superposition avec un microscope à deux objectifs, du type dit »Split-Field«. L'oeil de l'opérateur peut être avantageusement remplacé par un tube vidicon pour visualisation sur écran de télévision.

Suivant une technique plus élaborée, le signal vidéo obtenu par la caméra de télévision peut être traité pour obtenir un signal analogique ou numérique, utilisable par des circuits d'asservissement. Certains procédés utilisent par exemple le balayage d'une croix de St André et de son complément pour déterminer l'écart à l'alignement qui se traduit par un intervalle entre les fronts des signaux.

Les dispositifs mettant en oeuvre les procédés de l'art antérieur présentent deux inconvénients majeurs:

— le champ des motifs repères porté sur le masque et la plaquette semiconductrice est entièrement éclairé et, aux images de ces repères, se superpose un niveau de bruit non négligeable (réflexion parasite, diffusion, diffraction) qui conduisent à un mauvais rapport signal/bruit.

— le contraste des repères silicium est très variable d'un niveau d'intégration à l'autre, compte-tenu des variations d'épaisseur d'oxyde ou de la nature des dépôts (silicium polycristallin, aluminium). La qualité de l'alignement sera donc essentiellement variable. Elle dépend soit de l'acuité visuelle de l'opérateur, soit du pouvoir de résolution de l'électronique associée.

Il est également connu d'utiliser comme motifs-repères des réseaux optiques constitués d'une suite de traits parallèles dont la largeur et la distribution spatiale suivant la direction d'alignement sont déterminés par un code de répartition particulier. Le système d'alignement utilisant ce type de motifs-repères comporte une source monochromatique d'énergie lumineuse. Ces caractéristique sont portées dans le préambule de la revendication 1.

Cependant, cet art connu, illustré par la demande de brevet français FR-A-2 389 928 (Massachusetts institute of technology), s'applique aux classes d'alignement du type »proximité-contact«. Les deux motifs à aligner sont compris dans des plans parallèles dont la distance de séparation ne peut excéder, typiquement, quelques micromètres.

Dans le dispositif décrit dans cette demande de brevet, la source monochromatique d'énergie lumineuse produit un faisceau collimaté qui éclaire les réseaux superposés. Il se produit alors des ordres de diffraction successifs suivant la direction d'alignement, soit aux transmissions du faisceau au travers des réseaux, soit aux reflexions de ce faisceau ou des différents faisceaux diffractés sur ces réseaux. L'alignement est détecté en mesurant l'intensité résultant de la combinaison d'une partie déterminée des ordres de diffractions.

Bien qu'obviant en partie au second inconvénient précédemment rappelé, ce dispositif qui met en oeuvre une technique sans formation d'image, ne peut de ce fait être utilisé dans le cadre de la présente invention.

Pour pallier les inconvénients de l'art connu et répondre aux besoins précités, l'invention a donc pour objet un système optique d'alignement d'au moins un premier motif, porté par un premier support par rapport à un second motif, porté par un second support, constituant une référence fixe; les premier et second motifs comprenant chacun au moins un réseau optique principal (41, 11) constitué d'une suite de traits parallèles dont la largeur et la distribution spatiale suivant une première direction (C) sont déterminées par un code de répartition particulier; le système optique comprenant une source monochromatique d'énergie lumineuse ($S_0$); système caractérisé en ce que en outre les traits du premier motif interrompus périodiquement suivant une seconde direction (R) pour former un réseau optique à pas constant suivant cette direction; et en ce qu'il est prévu:

— des moyens optiques (CO, OP) pour concentrer l'énergie de ladite source monochromatique d'énergie lumineuse sur le second motif et illuminer le premier motif (41) par projection sur ce motif de l'image du second motif (11) avec un grandissement prédéterminé pour produire des ordres de diffraction suivant les première et seconde directions (C, R);

— et des moyens de détection (5) de l'intensité d'une partie prédéterminée ($R_1$) des ordres de diffraction suivant la seconde direction (R), l'intensité détectée passant par un maximum et l'alignement précis étant obtenu lorsque la corrélation spatiale du premier motif et de la projection de l'image du deuxième motif sur le premier motif est maximale.

L'invention a également pour objet un photo-répétiteur comprenant un système optique d'alignement pour l'alignement d'une plaquette semiconductrice, portant sur sa face supérieure une couche de résine photo-sensible et sur laquelle est inscrit le premier motif, par rapport à un réticule sur lequel est inscrit le second motif, ainsi que d'autres motifs à projeter sur la plaquette; et principalement caractérisé en ce qu'il comporte un objectif de projection utilisé alternativement pour la projection de l'image du second motif sur le premier motif pendant des phases d'alignement et pour la projection sur la plaquette en des endroits déterminés de l'image, des autres motifs pendant des phases d'exposition.

L'invention sera mieux comprise et d'autres caractéristiques apparaitront à l'aide de la description qui suit en référence aux figures annexées, parmi lesquelles:

— la figure 1 est un exemple de photo-répéteur dans lequel peut être mis en oeuvre le système optique d'alignement de l'invention;
— les figures 2 à 4 illustrent le phénomène physique mis en oeuvre par l'invention;
— la figure 5 est un schéma principe d'un système optique d'alignement selon une première approche de l'invention;
— la figure 6 est un schéma optique détaillé d'un photo-répéteur mettant en oeuvre le système optique d'alignement selon la première approche;
— les figures 7 à 12 se rapportent à des variantes du réseau optique utilisé dans les systèmes d'alignement de l'invention;
— les figures 13 et 14 illustrent un exemple de circuit électronique d'asservissement, associé aux systèmes d'alignement selon l'invention;
— la figure 15 représente une variante de réalisation d'un système optique d'alignement selon la première approche, mettant en oeuvre un objectif auxiliaire d'alignement angulaire;
— les figures 16 à 19 illustrent une seconde approche de système optique d'alignement selon l'invention;
— la figure 20 représente une réalisation particulière d'un système optique d'alignement selon l'invention mettant en oeuvre un objectif auxiliaire d'alignement (X-Y).

Dans ce qui suit, l'invention sera illustrée, sans que cela soit limitatif, par un système optique d'alignement mis en oeuvre dans un appareillage de transfert par photo-répétition directe sur silicium. Cet appareillage sera appelé plus brièvement photo-répéteur.

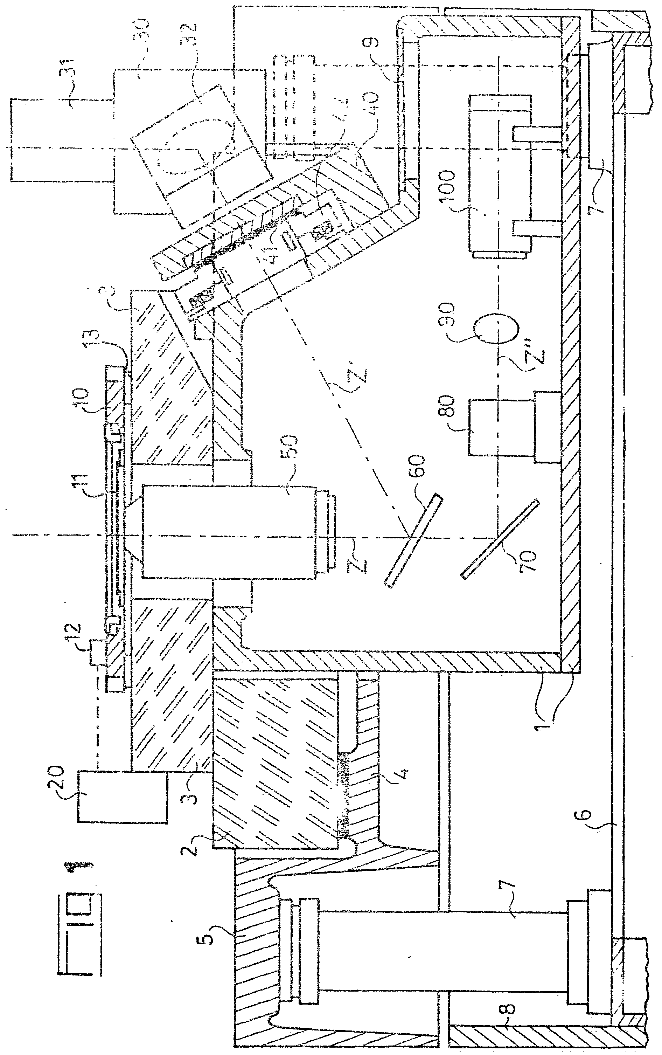

Un exemple de photo-répéteur est représenté sur la figure 1. Il comporte un bâti inférieur 8 et un bâti supérieur 5. Le bâti supérieur repose sur une platine 6, solidaire du bâti inférieur 8 par l'intermédiaire de colonnes 7 d'amortisseur à air. Le bâti supérieur 5 supporte par l'intermédiaire d'un patin amortisseur 4, un marbre porteur 2. Ce marbre porteur 2 constitue le socle d'un marbre de référence 3. Ce marbre 3 supporte une table X-Y non détaillée et un plateau correcteur 10, susceptible d'être déplacé suivant deux axes orthogonaux X et Y. L'amplitude de ces déplacements est de l'ordre d'une dizaine de microns par rapport à la table X-Y dont la course est de l'ordre de 150 mm. Ces déplacements relatifs sont commandés par deux groupes de céramiques piézoélectriques agissant respectivement suivant les axes X et Y. Les déplacements se font soit sous la commande de deux unités d'interférométrie à mouvements croisés, soit sous la commande des détecteurs d'alignement. Seuls l'interféromètre 20 et le miroir de mesure 12 suivant l'axe X ont été représentés. Ce procédé est du domaine de l'art connu, et les circuits de commande n'ont pas été représentés sur le schéma de la fugure 1. Un ensemble optique 1 est solidaire du marbre de référence 3. Il sera décrit avec plus de précision, car il comporte le système optique d'alignement objet de la présente invention. Les différents composants de cet ensemble optique 1 sont notamment un objectif de projection 50 et une embase porte-réticule 42. L'embase porte-réticule 42 est un commutateur de réticules sur lequel peuvent être fixés plusieurs réticules 41. Les reticules sont préalignés sur la machine par l'intermédiaire d'un plateau 40, mobile suivant deux axes X et Y et en rotation dans le plan défini par X et Y. La plaquette semiconductrice à insoler 11, recouverte d'une couche de résine photo-sensible est posée sur le plateau correcteur 10. Ce plateau correcteur peut glisser dans le plan du marbre de référence sur des coussins d'air 13. L'objectif de projection 50 peut se déplacer suivant l'axe Z. Il est muni de tous les organes de réglage habituels (qui ne sont pas représentés sur la figure 1). Sur ce réticule sont inscrits les motifs du circuit à projeter sur la plaquette de silicium 11, les motifs-repères objet de l'invention ainsi que des motifs de préalignement du réticule par rapport à la machine. L'ensemble optique 1 comporte également un miroir semitransparent 60, un deuxième miroir 70 et une optique de compensation 80, des moyens détecteurs d'alignement 90 et un tube vidicon 100. La fonction de ces différents composants sera décrite ultérieurement. L'ensemble optique comporte également une fenêtre d'accès 9 et une unité d'illumination 30, comprenant un condenseur et un miroir 32 ainsi qu'une source d'énergie lumineuse 31.

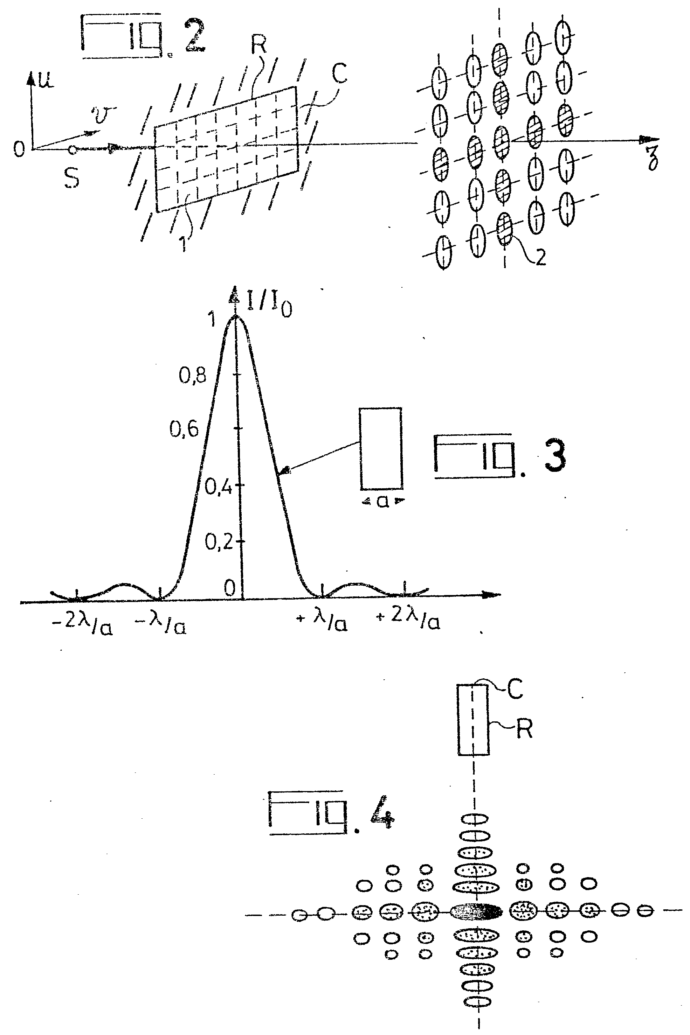

Le phénomène physique mis en oeuvre dans l'invention va tout d'abord être exposé en relation avec les figures 2 à 4. Dans ce qui suit, il va être fait usage de réseaux optiques. Un réseau optique est une surface, transparente ou réfléchissante, sur laquelle on a réalisé une perturbation périodique de transparence ou de réflexion, à pas très serré et comprenant un grand nombre de pas. Les réseaux utilisés dans le cadre de l'invention sont dotés de perturbations suivant deux directions orthogonales entre elles (u, v). Si on éclaire ce réseau par un faisceau provenant d'une source ponctuelle infiniment éloignée ou placée au foyer d'une lentille collimatrice, la lumière est transmise non seulement dans la direction de transmission ou de réflexion régulière, mais aussi dans un certain nombre de directions bien déterminées qui sont des maxima d'interférence. Les positions de ces maxima dépendent de la longueur d'onde. Ces maxima s'observent dans un plan situés à l'infini. Un moyen d'observer ces maxima à une distance finie est de placer une lentille après le réseau optique. On observe dans le plan focal de cette lentille des ordres de diffraction correspondant aux maxima. Ce plan est encore appelé plan de Fourier. Le réseau étant à deux dimensions, on observe des ordres de diffraction répartis selon deux axes privilégiés parallèles aux axes u et v. Ceci a été symbolisé sur la figure 2 par les taches 2. Les dimensions de ces taches 2 sont inversement proportionnelles aux dimensions (R, C) du réseau optique 1. Au voisinage des maxima d'interférence, la fonction décrivant l'intensité lumineuse n'est autre que la fonction de diffraction d'une pupille uniformément transparente de même dimension que le réseau optique. Cette fonction est représentée sur la figure 3. L'intensité passe par un minimum nul pour des valeurs $\lambda/a$, a étant égal aux longueurs R ou C (suivant les axes v ou u). L'allure des taches de diffraction est donnée par la figure 4. Si dans une direction le réseau optique comporte des perturbations distribuées d'une façon non régulière, on retrouve dans cette direction des raies de diffraction dont la répartition est fonction de l'agencement particulier des perturbations du réseau. C'est notamment le cas si la largeur et la distribution spatiale des perturbations sont déterminées par un code de répartition non uniforme. Ce code peut être un code pseudo-aléatoire, du type code de Barker. Un exemple de code sera décrit plus loin.

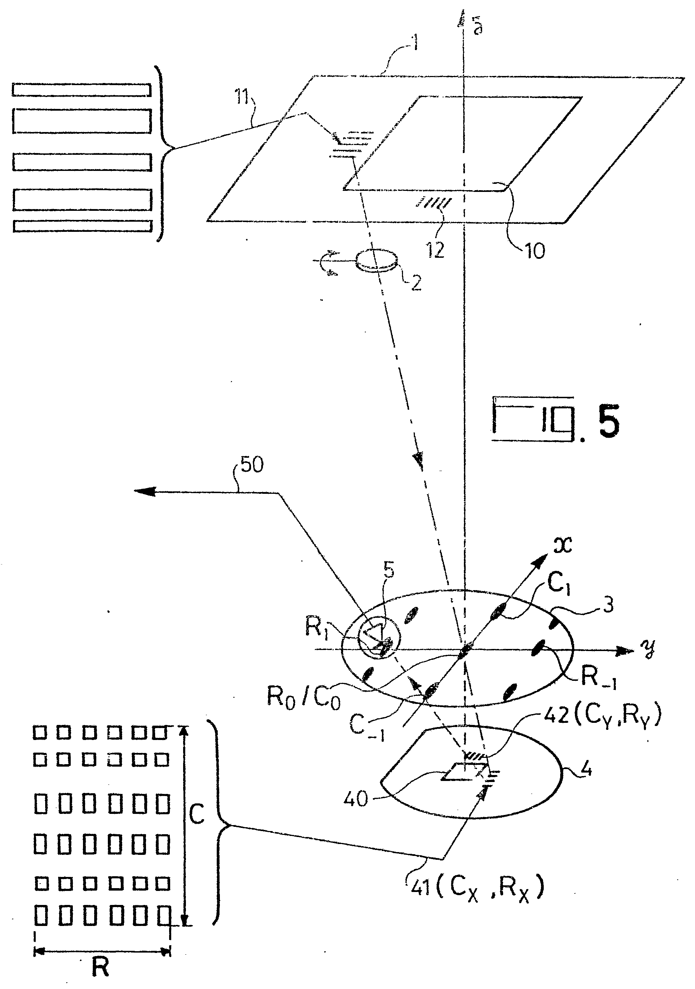

L'alignement selon l'invention, mettant en oeuvre les phénomènes physiques qui viennent d'être décrits est schématisé sur la figure 5. Une plaquette de silicium 4 sur laquelle doivent être projetés des motifs 10 portés sur un réticule 1 doit être alignée par rapport à ces motifs. Pour ce faire le réticule 1 et la plaquette 4 portent des motifs 11 et 12, respectivement 41 et 42, qui vont servir à l'alignement de la plaquette par rapport au réticule 1. Le réticule 1 et la plaquette 4 sont situés dans des plans perpendiculaires à l'axe optique Z d'un objectif (non représenté). Les motifs servant à l'alignement sont des réseaux optiques constitués par des traits parallèles à deux axes préférentiels X et Y orthogonaux entre eux. Les réseaux 11 et 12 sont des réseaux codés suivant une direction. Les réseaux 41 et 42 sont également codés suivant la direction C (respectivement $C_X$ et $C_Y$), avec le même code que les réseaux 11 et 12. D'autre part les traits composant ce code sont interrompus de façon régulière, suivant la direction R (respectivement $R_X$ et $R_Y$), et forment de ce fait un réseau à pas régulier suivant

4

cette direction. Sur la figure 5, seul l'alignement des réseaux 11 et 41 a été illustré, c'est à dire l'alignement suivant l'axe X. L'alignement suivant l'axe Y est identique.

L'image du réseau 11 va être projetée sur le réseau 41, à l'aide de moyens optiques appropriés non représentés. La dimension du réseau 11 est telle, qu'il puisse être superposé au réseau 41 suivant la direction C, compte-tenu du grandissement des moyens optiques. Comme il a été indiqué précédemment, le réseau 41, éclairé par l'image du réseau 11, va produire des ordres de diffraction suivant deux directions privilégiées, c'est à dire suivant les directions C et R (respectivement $C_X$, $R_X$ et $C_Y$, $R_Y$) ou ce qui revient au même, suivant les directions X et Y. On a représenté dans le plan de Fourier 3, les ordres de diffraction $C_0$, $C_1$, $C_{-1}$ et, suivant l'autre direction, $R_0$, $R_1$, $R_{-1}$. L'ordre de diffraction $R_1$ est détecté par un moyen optoélectronique 5. Les signaux de sortie 50 sont transmis à des moyens électroniques appropriés, non représentés. On peut également détecter l'ordre $R_{-1}$ et sommer les signaux représentant l'intensité de ces deux ordres ($R_1$, $R_{-1}$). Le réseau 42 pour l'alignement de la voie Y va diffracter dans des directions orthogonales aux directions de diffraction du réseau 41. Les ordres $R_1$ et $R_{-1}$ du réseau 42 peuvent être détectés sur l'axe X. Cette technique permet de discrimer spatialement les signaux d'alignement X et d'alignement Y, si les pas des réseaux dans les directions R et C sont distincts. Sinon le filtrage peut, par exemple, être réalisé en utilisant deux polarisations orthogonales de la lumière pour les réseaux X et Y. Les détecteurs sont alors équipés d'analyseurs permettant de sélectionner uniquement la lumière correspondante à la direction observée.

L'utilisation de réseau à deux dimensions est une des caractéristiques fondamentales de l'invention et permet d'éviter deux inconvénients:

— les réseaux du réticule produisent eux-mêmes des ordres de diffraction lorsqu'ils sont illuminés. L'utilisation d'ordres de diffraction suivant la direction C conduirait à des risques de perturbations dûs à des réflexions et diffusions parasites.
— si on utilisait les ordres de diffraction suivant la direction C, on devrait introduire des éléments d'optiques supplémentaires sur le trajet des rayons d'alignement (par exemple des miroirs semi-réfléchissants) qui perturberaient la projection de l'image des réseaux du réticule projetée sur les réseaux de la plaquette semiconductrice.

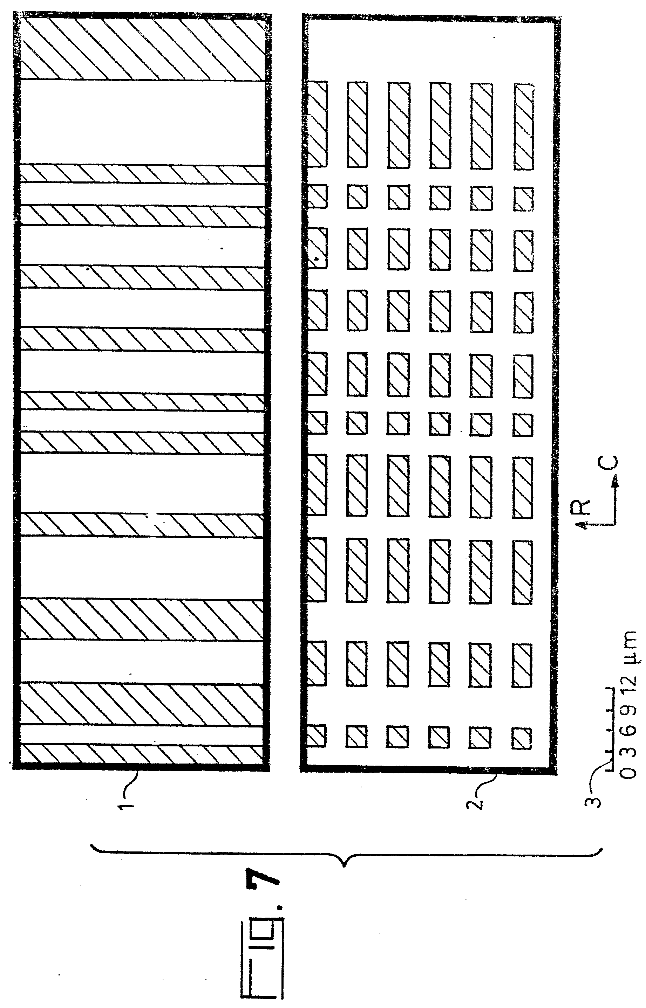

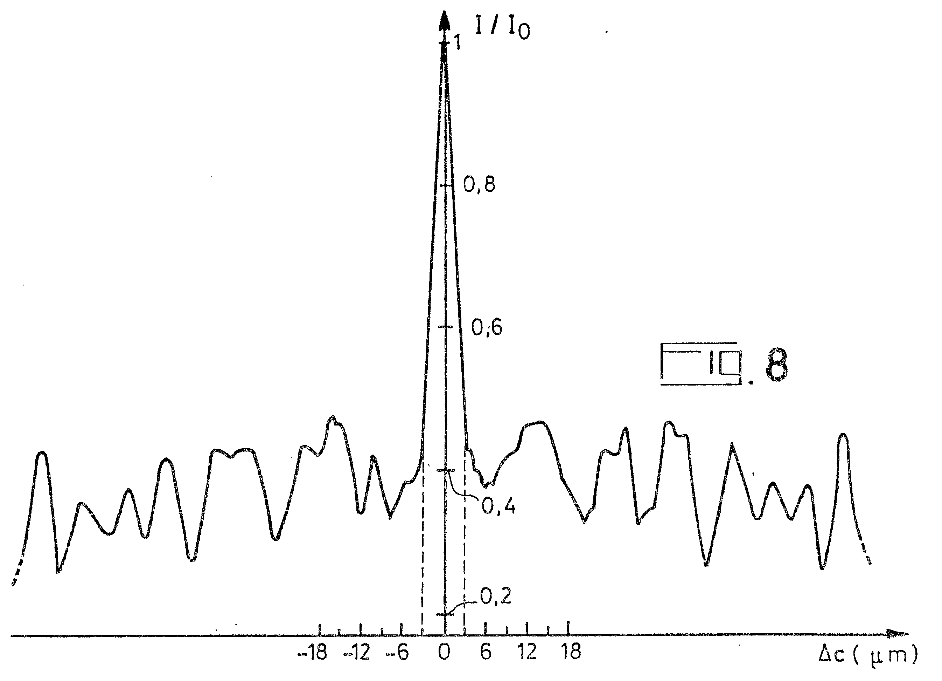

La figure 7 illustre un exemple de code utilisable. En 1 est représenté le code 11 (ou 12) de la figure 5 inscrit sur le réticule, en 2 est représenté le code 41 (ou 42) inscrit sur la plaquette semi-conductrice. En 3, est représentée l'échelle. Suivant la direction R le pas est constant, de 3 μm; suivant la direction C le pas est variable. La superposition de ces deux codes, c'est à dire la superposition de l'image du code 1 sur le code 2, fait que l'intensité détectée dans les ordres $R_1$ et $R_{-1}$ sera maximale. La figure 8 est une courbe de réponse normalisée de l'intensité détectée par les moyens de détection 5. Cette courbe a été obtenue par l'expérimentation. On observe un pic de corrélation très sélectif et, hors coincidence, c'est à dire en dehors de l'alignement lorsque la projection de l'image du code 1 sur le code 2 ne donne pas la juxtaposition exacte d'un côté ou d'un autre, suivant la direction C, la réponse moyenne s'établit aux environs de 40% du maximum, pour ce code particulier.

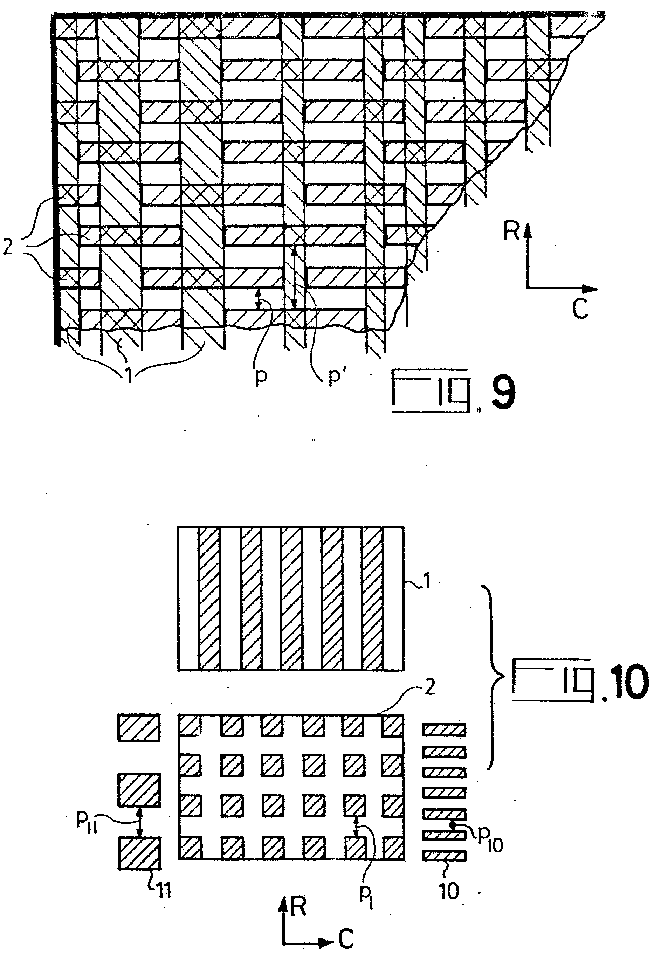

D'autres structures sont utilisables, à titre d'exemple de variantes, on peut imaginer un réseau réticule 1, identique au réseau 1 de la figure 7 et un réseau de plaquette 2 imbriqué, comme représenté sur la figure 9. Suivant la direction R, des ordres de diifraction apparaissent à des endroits différents selon que l'on soit ou non à l'alignement. Le réseau 2 se comporte comme la superposition de deux réseaux à pas régulier imbriqués: l'un des pas p et l'autre p'.

Bien que ce type de réseau codé, présente un pic de corrélation prédominant, le niveau de signal moyen hors alignement varie, selon le code choisi, entre 25% et 50%. D'autre part suivant la direction C, on peut assimiler le réseau à une somme de réseaux à pas constant et tous différents les uns des autres. Il s'en suit que l'on observe suivant cette direction des ordres diffractés correspondant à chacun de ces pas qui peuvent brouiller la détection des ordres R du réseau suivant l'autre direction d'alignement.

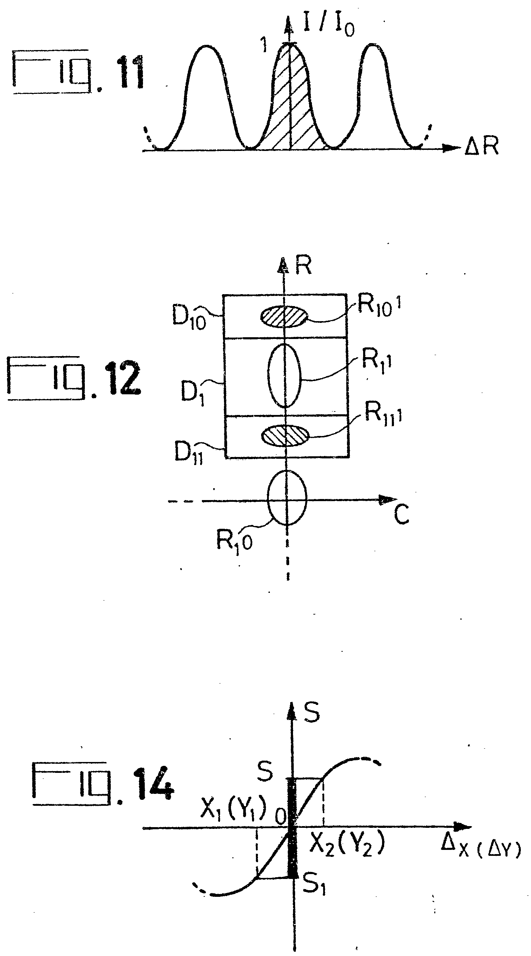

Pour pallier ces difficultés on peut choisir un réseau (R-C) de pas constant suivant ces deux directions. Cependant si on éclaire le réseau 2, à pas constant $p_1$, de la figure 10 par l'image d'un réseau à pas constant 1, inscrit sur le réticule 2, la courbe de réponse à l'alignement et hors alignement est donné par la figure 11. On constante une suite de maxima dûs à la périodicité du réseau. Pour lever l'indétermination, on va placer deux réseaux auxiliaires 10 et 11 (également à pas constant, mais différents l'un de l'autre: $p_{10}$ et $p_{11}$ et différents du pas $p_1$ du réseau principal 2) de part et d'autre du réseau 2, suivant la direction C. Hors alignement, un de ces réseaux va diffracter également dans la direction R, selon que l'image du code 1 est projetée sur le réseau 2 trop à droite ou trop à gauche, suivant la direction C. Ce résultat est illustré sur la figure 12. En plus des ordres du réseau principal $R_1 0$ et $R_1 1$, on trouve les ordres des réseaux 10 et 11: $R_{11} 1$, et $R_{10} 1$. Ces deux derniers ordres étant exclusifs l'un de l'autre. Si on place, suivant la direction R, trois détecteurs $D_1$, $D_{10}$ et $D_{11}$, l'alignement se fait en deux phases: pendant la première phase ou alignement grossier, l'un des deux ordres $R_{10} 1$ ou $R_{11} 1$ est détecté, on détermine ainsi la direction du non-alignement et on agit sur les organes commandant le déplacement de la plaquette; pendant la seconde phase ou alignement fin seule l'intensité de l'ordre $R_1 1$ du réseau principal est mesurée. On se déplace alors sur la partie centrale hachurée de la figure 11.

Comme précédemment, les ordres R_1 peuvent également être détectés. L'intérêt de cette méthode tient en une meilleure dynamique de la réponse: en effet la courbe de la figure 11 passe, thériquement, par zéro hors alignement, c'est à dire que le bruit de fond est très faible dans le cas d'une réalisation concrète.

On peut imaginer d'autres variantes: en particulier le silice gravé qui va constituer le réseau, peut avoir des bords de traits arrondis qui vont diffracter suivant une couronne dont le rayon dépend du pas de réseau. On peut donc se placer en différents points de la couronne, no perturbés par les réflexions parasites, pour détecter le signal de corrélation.

L'avantage principal de tous ces procédés, ou l'acuité visuelle n'intervient pas, est d'offrir un signal indépendant, au premier ordre, du contraste de l'image sur la plaquette. On peut donc utiliser les repères inscrits au premier niveau d'intégration, pour toute la succession des niveaux suivants.

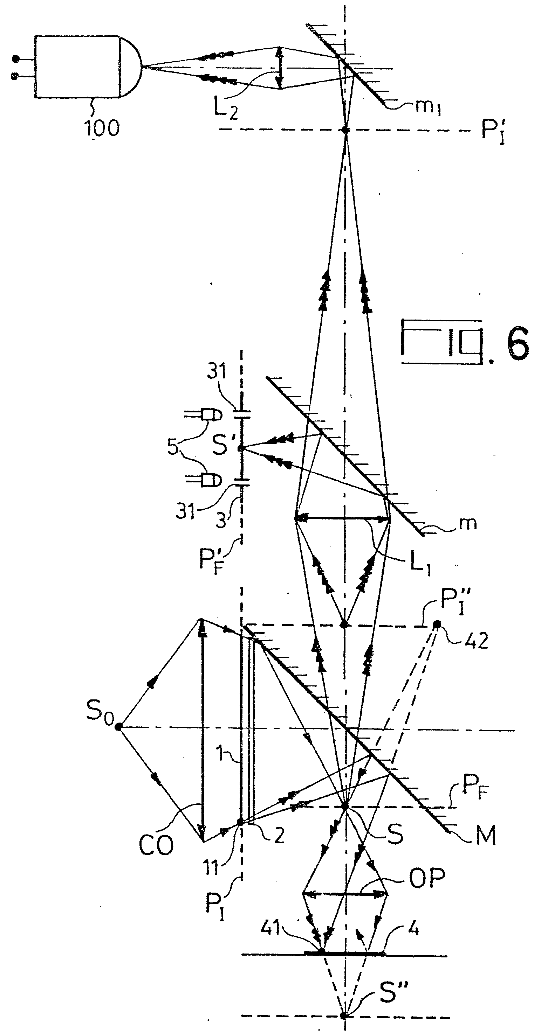

La figure 6 est un schéma optique détaillé d'un photo-répéteur mettant en oeuvre le système d'alignement selon une première approche de l'invention. Une source d'énergie lumineuse $S_0$ illumine le réticule 1 au travers du condenseur CO, un miroir M semi-réfléchissant donne de cette source $S_0$, une image S. Cette image S est reprise par l'optique de projection OP qui en donne une image S''. La plaquette semiconductrice à insoler est placée en 4. Un motif 11 du réticule est imagé en 41 par le miroir M et l'optique de projection OP; ce motif 11 peut être un des réseaux qui viennent d'être décrits. Son image va illuminer un réseau 41 ce qui produit des ordres de diffraction dans le plan de Fourier $P_F$ ce plan est confondu avec S. Il est plus pratique d'observer les ordres de diffraction non pas dans le plan $P_F$, mais dans un plan image de ce plan $P_F$ : $P'_{F'}$, donné par une optique auxiliaire comportant une lentille $L_1$ et un second miroir semi-transparent m. Dans ce plan $P'_F$ va être placé und disque opaque comportant deux diaphragmes 31, derrière lesquels on place des détecteurs opto-électroniques 5. Cette optique permet également une visualisation simultanée de la superposition de l'image du réseau 11 et du réseau 41. Le miroir M donne de 41 une image 42, dans un plan $P''_I$, image du plan $P_I$ du réticule 1. Ce plan est à son tour imagé en $P'_I$, à l'aide de la lentille $L_1$, au travers du miroir semi-transparent m. Ce plan image $P'_I$, à l'aide d'un miroir $m_1$ et d'une lentille $L_2$, est projeté sur un tube vidicon 100, associé à des moyens de visualisation non representés. Cette visualisation des images des repères 41 sur le tube vidicon sert d'aide à la mise au point et au contrôle du bon fonctionnement, mais n'intervient pas dans l'alignement.

Bien que sur la figure 6, il n'ait été représenté qu'un couple de repères d'alignement réticule-plaquette, respectivement 11−41, par exemple pour l'alignement X, il est nécessaire de prévoir un deuxième couple de repères (non représentés) pour l'alignement Y. On place pour la détection un second couple de détecteurs orthogonaux aux détecteurs 5. Si un réseau tel que celui de la figure 10 est utilisé, on prévoit des détecteurs supplémentaires pour les réseaux auxiliaires ($R_{10}$, $R_{11}$).

Dans cette première approche la voie d'alignement est commune en grande partie à la voie projection. On doit donc, en premier lieu, disposer de deux sources de longueurs d'onde différentes. En effet la source $S_0$ illuminant le repère 11 d'alignement ne doit pas sensibiliser la résine de la plaquette semiconductrice 4 pour l'alignement. On peut utiliser un laser HeNe de longuer d'onde 6328 Å pour l'alignement et une lampe au mercure, associée à des filtres de raies, pour la projection. L'optique de projection est corrigé pour une longueur d'onde de 4050 Å (ou 4358 Å ou 3650 Å selon la raie sélectionnée). Pour obtenir une image nette du réseau 11 sur la plaquette 4 (au bon grandissement), il est nécessaire d'introduire dans le trajet optique entre l'objectif et le réticule, une optique de compensation 2. Ce peut être une lame transparente parallèle de bonne qualité optique ($\lambda/10$) ou une optique de faible puissance. Cette lame peut également être utilisée pour moduler la position respective des repères réticules 11 par rapport au repère plaquette 41, de façon à obtenir un signal modulé en sortie des détecteurs. La position XY de cette optique n'est pas critique, seule compte sa position angulaire. C'est le seul organe qui doit être commuté entre les phases d'alignement et les phases de projection. Sa mise en place et son retrait peuvent être rapides.

La modulation du signal détecté peut être aussi obtenue par une faible modulation de la position XY de la plaquette (quelques dixièmes de microns).

D'autre part, le faisceau laser peut également être modulé en tout ou rien, à fréquence élevée. Les signaux détectés par les moyens opto-électroniques 5, sont exploités par des circuits électroniques associés, qui permettent de rendre entièrement automatique le processus d'alignement.

Un exemple de ces circuits électroniques est donné par la figure 13. Seule la voie d'alignement X a été représentée, la voie d'alignement Y étant identique. Les signaux recueillis par les organes opto-électroniques 5 sont transmis à une unité d'amplification et de mise en forme 3. La lame 2 de la figure 6 est entrainée par une unité 6 chargée de lui imprimer une vibration d'amplitude constante et de fréquence donnée. Le signaux de commande sont produits par un générateur de signal de modulation 7 et transmis sur la liaison 60. Le générateur 7 transmet également des signaux de synchronisation (par la liaison 81) à un détecteur synchrone 8. Une unité de modulation 20 de l'intensité du faisceau laser transmet des signaux de commandes (via la liaison 11) à un obturateur rapide 1. Des signaux de synchronisation sont également transmis, (via la liaison 40), à une unité de détection hétérodyne 4 qui reçoit les signaux de sortie de l'unité 3 (via la liaison 41). Le signal de sortie de cette unité 4 est transmis à un amplificateur basse fréquence 50 (via la liaison 51). Un détecteur synchrone 8 reçoit d'une part les signaux de sortie de l'amplificateur basse fréquence 50 (via la liaison 80) et, d'autre part, les signaux de sortie du générateur 7 (via la liaison 81). Le signal de sortie du détecteur synchrone (sur la liaison 100) est transmis à un amplificateur de puissance 10 qui commande (via 90) le moteur d'entraînement 9 de la voie X.

Après traitement les signaux détectés par l'unité 3 pour la voie X (ou pour la voie Y) donnent des signaux d'asservissement dont l'allure est représentée sur la figure 14. Ces signaux peuvent être exploités pour réaliser un alignement automatique correspondant à une précision donnée. En effet on peut définir, après une phase de mise au point globale initiale pendant laquelle on amène en superposition exacte de l'image des réseaux X et Y du réticule avec les réseaux correspondants de la plaquette, une plage, à l'intérieur de laquelle le signal d'asservissement doit rester pour satisfaire une condition d'alignement correspondant à une plage L, identique pour le décalage suivant X et le décalage suivant Y : $\Delta L = X_1 X_2 = Y_1 Y_2$. Pour ce faire, on définit deux seuils S1 et S2 correspondant à une variation de l'alignement $\Delta X = X_1 X_2$ (ou $\Delta Y = Y_1 Y_2$). Avant toute nouvelle exposition, on vérifie si le signal S est à l'intérieur de cette plage $\Delta X$ ($\Delta Y$) $< \Delta L$. Cette détection peut se faire par des moyens électroniques à seuil (non représentés) qui déclenchent ou non, en fonction du résultat, un réajustement local de la plaquette. Il s'en suit un gain de temps (car on ne fait pas systématiquement un réalignement) et un gain de précision car on peut s'adapter à tout cas particulier. La figure 13 n'est qu'un exemple parmi d'autres de chaine d'asservissement utilisable dans le cadre de l'invention. Ces circuits sont bien connus de l'homme de métier et ne seront pas décrits plus avant.

En plus de l'alignement selon deux axes de coordonnés, respectivement X et Y qui vient d'être décrit, la plaquette de silicium doit, dans une phase initiale d'alignement global, être positionnée angulairement ($\Theta$). Un premier procédé d'alignement X, Y et $\Theta$ a été décrit dans la demande de brevet français déposée le 20 Avril 1977 par la demanderesse sous le N° 7 711 908 et publiée sous le N° 2 388 371. Selon ce procédé, deux couples de repères d'alignement X et Y sont également utilisés pour l'alignement $\Theta$.

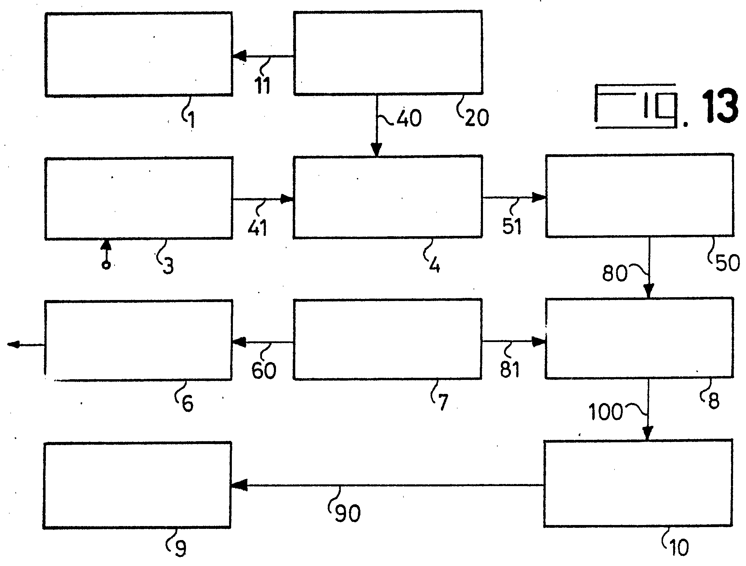

Selon une variante qui va être décrite en relation avec la figure 15, on peut également utiliser un objectif auxiliaire OA pour réaliser l'alignement angulaire. On retrouve sur cette figure les différents organes nécessaires à l'alignement X et Y. L'axe de rotation de la plaquette 4 est confondu avec l'axe optique de l'objectif de projection utilisé, comme précédemment décrit, pour l'alignement X et Y, ainsi que pour la projection proprement dite. Pour l'alignement angulaire $\Theta$ on utilise un objectif auxiliaire OA, un repère machine supplémentaire 100 A, ainsi qu'une optique auxiliaire comprenant un miroir semi-transparent M' et une lentille $L'_1$, ainsi qu'un ensemble de détection $30-50$. L'origine de la photorépétition est établie à partir de l'objectif de projection OP ce qui permet le maximum de précision et de rapidité. Les corrections ultérieures sur l'alignement se font selon les principes précédemment décrits de façon automatique, en agissant uniquement sur X et Y.

A titre d'exemple non limitatif, les organes suivants peuvent être utilisés pour la réalisation concrète d'un système d'alignement selon l'invention:

| | |
|---|---|
| — objectif de projection | marque CERCO, référence 744, rapport de réduction 1/5 |
| — source d'illumination d'alignement | laser HeNe, $\lambda = 6328$ Å |
| — source d'illumination pour la projection | lampe au mercure à spectre étendu, associée à des filtres pour sélectionner la raie $\lambda = 4050$ Å |
| — moyens optoélectroniques de détection | photodiodes: marque EGG, type SGD 100 ou HAD 1000 A, ou photomultiplicateur: marque R. T. C., type XP 1117 (miniphotomultiplicateur) |
| — miroir semi-transparent M | miroir multidiélectrique<br>— coefficient de réflexion 0,99 dans la gamme: 4050 Å $< \lambda <$ 4350 Å<br>— coefficient de transmission d'environ 0,5 pour $\lambda = 6328$ Å |

Les autres composants (lentilles, microscopes, etc...) sont choisis parmi ceux habituellement utilisés pour les photorépéteurs de l'art ancien.

Dans l'approche qui vient d'être décrite, on ne fait pas intervenir de commutation mécanique précise, c'est à dire de commutations d'éléments nécessaires à l'alignement et gênants pour la projection. Seule l'optique de compensation de la figure 3 doit être commutée. Cette commutation, peut avoir lieu pendant des déplacements de la table XY et ne prolonge donc pas le temps de transfert sur la plaquette semi-conductrice.

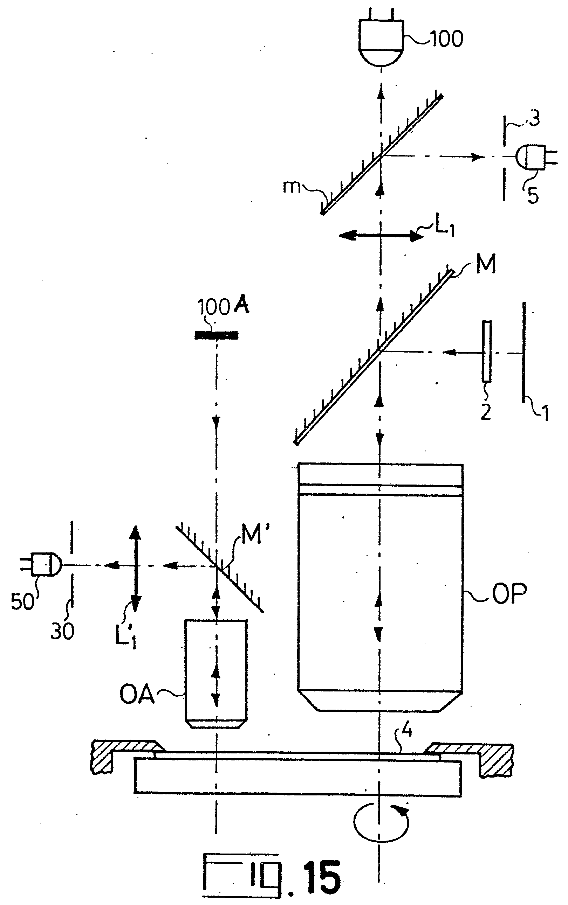

Cependant il peut être intéressant de dissocier complètement la voie de projection de la voie d'alignement. Un photorépéteur, réalisé selon cette seconde approche, va être décrit en relation avec les figures 16 à 19. Selon cette approche le réticule 1 et la plaquette semi-conductrice 4 sont indexés par rapport à des repères connus, liés au photorépéteur.

La figure 16 décrit la première phase de l'alignement. Des repères d'alignement $R_{21}$ et $R_{22}$, respectivement pour l'alignement en X et en Y, sont alignés par rapport à des repères de référence $R_{31}$ et $R_{32}$, fixes dans la machine. Les images des repères $R_{21}$ et $R_{22}$, situés dans le plan 6, sont projetées resprectivement sur les repères R$_{31}$ et R$_{32}$ à l'aide des lentilles L$_4$ et L$_3$, et des miroirs M$_2$ et M$_1$. L'alignement est détecté par utilisation de moyens opto-électroniques 501 et 502. Ces moyens sont munis d'une optique collimatrice concentrant la lumière recueillie sur R$_{31}$ et R$_{32}$. A l'alignement, le signal en sortie de ces deux détecteurs sera maximum. Cette phase est une phase de contrôle ou de pré-réglage, qui n'est effectuée que périodiquement (par exemple une fois par jour).

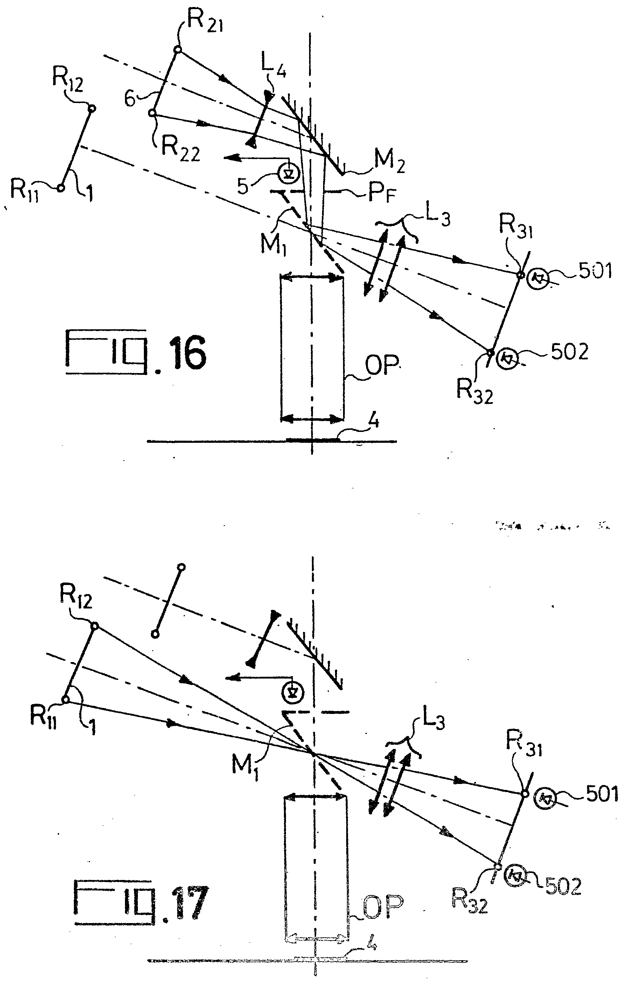

La figure 17 illustre la deuxième phase de l'alignement. Cette deuxième phase correspond à la mise en place du réticule 1 et à son alignement par rapport aux mêmes repères R$_{31}$ et R$_{32}$. Pour ce faire, le réticule porte deux repères R$_{12}$ et R$_{11}$. Cette phase n'intervient qu'au début du travail de photorépétition et n'est effectuée que lorsque l'on change le réticule.

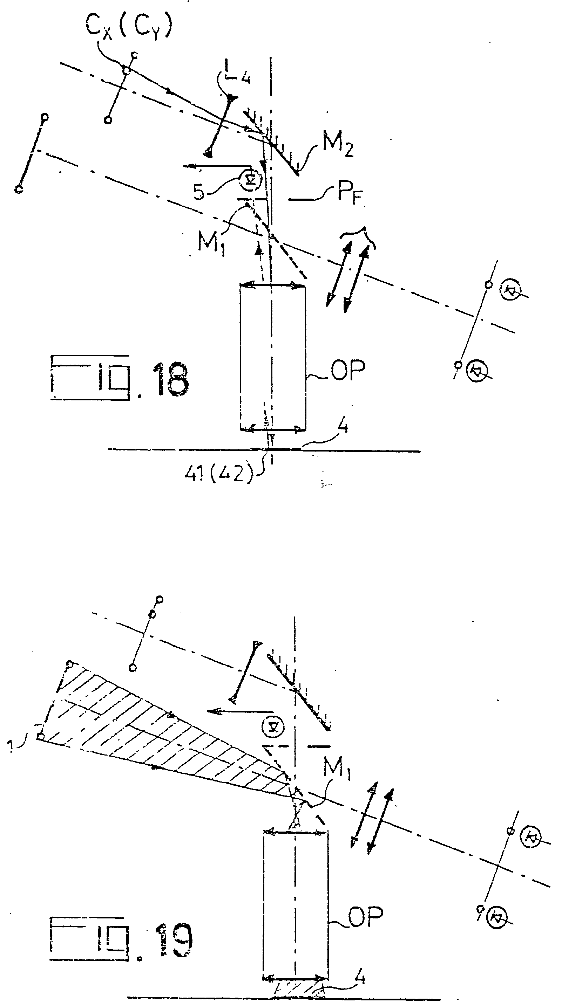

La figure 18 illustre la troisième et dernière phase de l'alignement. Pendant cette phase, qui doit être la plus rapide et la plus fréquente, la plaquette de silicium 4 est alignée par rapport à des repères C$_X$ et C$_Y$, qui peuvent être les repères R$_{21}$ et R$_{22}$. Ces repères peuvent être éclairés en permanence et la détection est instantenée. Les images des repères R$_{21}$ et R$_{22}$ sont projetées sur les repères gravés sur la plaquette de silicium 4 : 41 ou 42 à l'aide de la lentille L$_4$, de l'objectif de projection OP et des miroirs M$_2$ et M$_1$. Les repères 41 et 42, éclairés par les images de R$_{21}$ et R$_{22}$, vont diffracter des ordres de diffraction, entre autre, suivant les directions R qui vont être détectés dans le plan de Fourier P$_F$, à l'aide d'un moyen opto-électronique 5 selon les principes qui ont été exposés en relation avec la première approche.

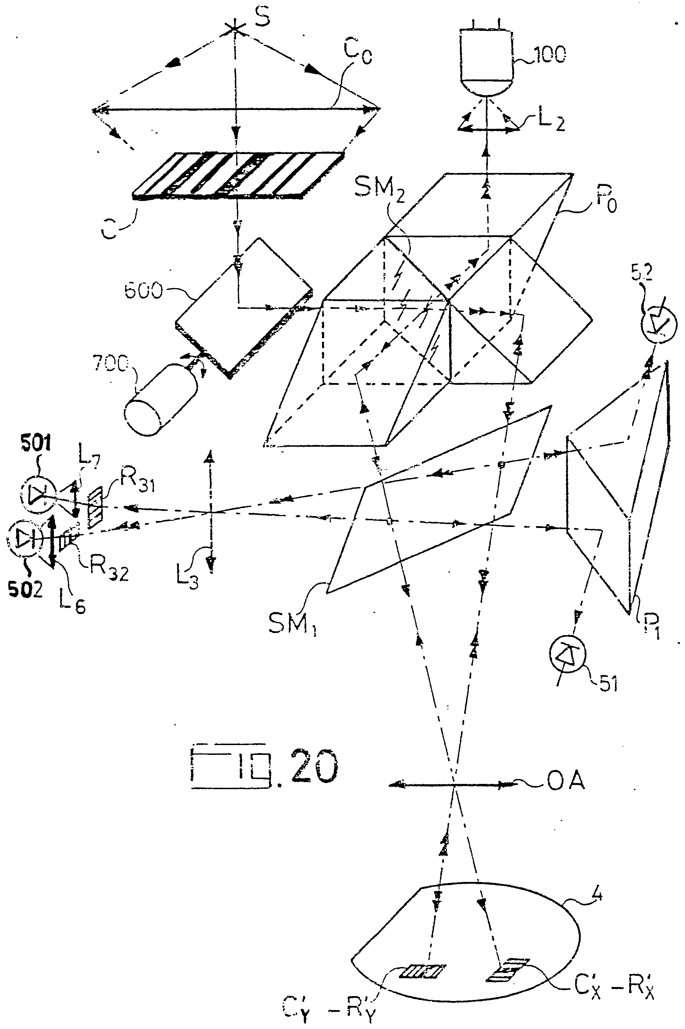

La figure 19 illustre la phase ultérieure pendant laquelle la plaquette 4 est insolée, c'est à dire pendant le transfert.

Dans l'approche qui vient d'être décrite, la voie alignement et la voie projection sont entièrement distinctes. Aucune commutation n'est plus nécessaire. La compensation optique (non représentée) réalisée par la lame 2 dans la figure 6, peut être effectuée en dehors du trajet du faisceau de projection.

La figure 20 représente une variante de réalisation selon la deuxième approche, c'est à dire avec utilisation de repères supplémentaires et découplage des voies alignement et voies projection. Selon cette variante, l'alignement XY est réalisé à l'aide d'un objectif auxiliaire OA. De plus, l'image du code C, illuminé par la source S cia le condenseur CO est dédoublée par un ensemble de prismes P$_0$, formant également miroir semi-transparent SM$_2$. Les rayons lumineux ainsi dédoublés sont réfléchis par un deuxième miroir semi-transparent SM$_1$ et sont projetés par la lentille L$_3$ sur des repères machine R$_{31}$ et R$_{32}$. Deux ensembles opto-électroniques, respectivement L$_6$-502 et L$_7$-501, sont utilisés pour réaliser l'alignement des images dédoublées de C par rapport à ces repères machine. La superposition des images dédoublées de C sur les repères R$_{31}$ et R$_{32}$ est obtenue à l'aide d'un miroir 600, entrainé par une unité de balayage 700. Cette unité imprime au miroir 600 un pivotement alterné d'amplitude constante et de fréquence donnée. On détermine ainsi à la coïncidence des images de C sur R$_{31}$ et R$_{32}$ un angle $\alpha_0$ du miroir 600 qui sert de référence initiale. Les images dédoublées sont également projetées au travers du miroir semi-transparent S$_{M1}$ et à l'aide de l'objectif OA sur deux repères gravés sur la plaquette de silicium 4 respectivement C'$_X$ − R'$_X$, C'$_Y$ − R'$_Y$. Ces deux repères illuminés par les images dédoublées de C vont produire des ordres d'interférence dans le plan de Fourier, comme il a été exposé précédemment. Ces ordres vont être détectés par des moyens opto-électroniques 51 et 52 après réflexion sur le miroir semi-transparent SM$_1$ suivant les directions R'$_X$, R'$_Y$ et les deux faces réfléchissantes d'un prisme P$_1$. De plus, l'image de C'$_X$ et C'$_Y$ éclairée par l'image dédoublée de C, est reprise par l'ensemble des prismes P$_0$ pour permettre une visualisation sur un tube vidicon 100, préxédé d'une lentille convergente L$_2$.

Dans tout ce qui précède, la discrimination entre les axes X et Y d'alignement a été obtenue par une discrimination du type spatiale. D'autres variantes peuvent être mises en oeuvre et sont applicables à toutes les réalisations qui ont été décrites.

Selon une première variante, dans une première phase les repères nécessaires à l'alignement selon l'axe X sont éclairés et cet alignement réalisé. Dans une deuxième phase, les repères nécessaires à l'alignement suivant un axe Y sont ensuite éclairés et l'alignement correspondant réalisé. Pour ce faire, on peut utiliser deux obturateurs (exclusifs l'un de l'autre), illuminant à tour de rôle la voie d'alignement X et la voie d'alignement Y.

Selon une seconde variante, la source d'illumination à laser est modulée par deux fréquences différentes, par exemple f1 = 1 MHz, f2 = 300 KHz. Une électronique adaptée pourra discirminer ces deux fréquences qui correspondent aux deux voies d'alignement X et Y.

Selon une troisième variante on peut utilise deux faisceaux polarisés différemment: le premier illuminant les repères nécessaires à l'alignement de la voie X, le second les repères nécessaires à l'alignement de la voie Y. A titre d'exemple non limitatif, le premier faisceau a une polarisation linéaire parallèle à la direction C$_X$, le second à la direction C$_Y$. On place un analyseur les moyens opto-électroniques de détecxtion.

Dans les trois variantes précédentes, on peut utiliser les fibres optiques pour illuminer les repères correspondant aux voies X et Y, par des faisceaux lumineux convenablement conditionnés au préalable.

L'invention n'est par limitée aux réalisations qui viennent d'être décrites. En particulier le système d'alignement selon l'invention peut être appliqué à d'autres dispositifs qu'un photorépéteur. Le système d'alignement de l'invention peut être appliqué à tout dispositif utilisé pour aligner un ou plusieurs objets sur lesquels sont portés au moins un motif d'alignement, par rapport à un motif de référence porté par un support fixe. La réalisation de l'alignement se fait par détection, suivant une direction privilégiée, des ordres de diffraction obtenue par projection de l'image du motif de référence sur le ou les motifs d'alignement portés sur les objets à aligner.

## Revendications

1. Système optique d'alignement d'au moins un premier motif, porté par un premier support mobile (4), par rapport à un second motif, porté par un second support (1), constituant une première référence fixe; les premier et second motifs comprenant chacun au moins un réseau optique principal (41, 11) constitué d'une suite de traits parallèles dont la largeur et la distribution spatiale suivant une première direction (C) sont déterminées par un code de répartition particulier; le système optique comprenant une source monochromatique d'énergie lumineuse ($S_0$); système caractérisé en ce que en outre les traits du premier motif sont interrompus périodiquement suivant une seconde direction (R) pour former un réseau optique à pas constant suivant cette direction; et en ce qu'il est prévu:

— des moyens optiques (CO, OP) pour concentrer l'énergie de ladite source monochromatique d'énergie lumineuse sur le second motif et illuminer le premier motif (41) par projection sur ce motif de l'image du second motif (11) avec un grandissement prédéterminé pour produire des ordres de diffraction suivant les première et seconde directions (C, R);
— et des moyens de détection (5) de l'intensité d'une partie prédéterminée ($R_1$) des ordres de diffraction suivant la seconde direction (R), l'intensité détectée passant par un maximum et l'alignement précis étant obtenu lorsque la corrélation spatiale du premier motif et de la projection de l'image du deuxième motif sur le premier motif est maximale (fig. 5 et 6).

2. Système selon la revendication 1, caractérisé en ce que le second support (1) est en matériau transparent sur lequel est inscrit le second motif comprenant au moins un réseau optique principal (11) constitué par des traits définissant des zones alternées différenciées par leurs coefficients de transmission; et en ce que le premier support (4) est en matériau réfléchissant sur lequel est gravé le premier motif comprenant au moins un réseau optique principal (41) constitué par des traits définissant des zones alternéss différentiées par leurs coefficients de réflexion (fig. 5).

3. Système selon les revendications 1 et 2, caractérisé en ce que le code de répartition particulier est tel que les zones alternées différentiées par leurs coefficients de transmission du second motif, et les zones alternées différentiées par leurs coefficients de réflexion du premier motif, se répartissent de façon non uniforme; les deux motifs restant homothétiques.

4. Système selon la revendication 3, caractérisé en ce que en outre, chaque réseau optique principal du premier motif est constitué par deux réseaux identiques imbriqués à pas constant (p') suivant la seconde direction (R) et décalés l'un par rapport à l'autre suivant la première direction (C) pour créer un réseau optique composite ayant deux valeurs discrètes de pas constant (p, p') suivant la seconde direction (R), de manière à produire deux séries d'ordres de diffraction, spacialement distinctes; l'alignement étant obtenu lorsque l'intensité détectée d'une partie prédéterminée de l'une des deux séries d'ordres de diffraction suivant la seconde direction (R) est maximale (fig. 9).

5. Système selon les revendications 1 et 2, caractérisé en ce que le code de répartition particulier est tel que les zones alternées différentiées par leurs coefficients de transmission du second motif, et les zones alternées différentiées par leurs coefficients de réflexion du premier motif, définissent un réseau optique principal à pas constant ($p_1$) suivant la première direction (C) et en ce qu'il est prévu de part et d'autre de réseau optique principal du premier motif, suivant la première direction (C), un premier réseau optique latéral et un second réseau optique latéral, tous deux à pas constant suivant la seconde direction (R); les pas ($p_{10}$, $p_{11}$) des premier et second réseaux optiques latéraux étant différents l'un de l'autre et différents du pas ($p_1$) du réseau principal, de façon à créer suivant la seconde direction (R) des ordres de diffraction ($R_{10}$, $R_{11}$) distincts de ceux ($R_1$) du réseau principal (fig. 10).

6. Système selon la revendication 5, caractérisé en ce qu'il est prévu des premier et second moyens de détection supplémentaires ($D_{10}$, $D_{11}$) de l'intensité d'une partie prédéterminée des ordres de diffraction des réseaux latéraux, permettant d'effectuer une approche avant l'alignement précis (fig. 12).

7. Système selon l'une quelconque des revendications 1 à 6, caractérisé en ce que les moyens optiques comprennent au moins une lentille convergente (CO) concentrant l'énergie lumineuse de la source de lumière monochromatique à travers le second motif et un objectif de projection (OP) conjugant optiquement le second motif et le premier motif; et en ce que les rayons diffractés résultants de la projection traversent en retour l'objectif de projection pour être détectés dans l'image ($p'_F$) du plan de Fourier ($p_F$) (fig. 6).

8. Système selon l'une quelconque des revendications 1 à 7, caractérisé en ce que les premier et second motifs sont constitués chacun par deux réseaux optiques (41, 42 – 11, 12) et en ce que la première direction $(C_X)$ du premier réseau est parallèle à un premier axe de coordonnée (X) et la première direction $(C_Y)$ du second réseau étant parallèle à un second axe de coordonnée (Y), perpendiculaire au premier axe de coordonnée, de telle sorte que l'alignement du premier motif puisse se faire suivant deux axes de coordonnées orthogonaux (fig. 5).

9. Système selon la revendication 8, caractérisé en ce qu'il comprend en outre deux obturateurs de manière à ce que les premier et second réseaux optiques du premier motif soient illuminés séquentiellement; l'alignement selon les deux axes de coordonnées (X, Y) étant réalisé en détectant en synchronisme avec l'illumination des premier et second réseaux optiques, une partie prédéterminée des ordres de diffraction suivant la seconde direction $(R_X,$ respectivement $R_Y)$ des premier et second réseaux optiques (fig. 5).

10. Système selon la revendication 8, caractérisé en ce que, les premier et second réseaux optiques du premier motif étant illuminés simultanément par des premier et second faisceaux lumineux, modulés resprectivement à une première fréquence $(f_1)$ et à une seconde fréquence $(f_2)$, il comprend en outre des moyens électroniques adaptés pour discriminer ces deux fréquences; chacune de ces deux fréquences étant associée à l'alignement selon l'un desdits deux axes de coordonnées (X, Y) (fig. 13).

11. Système selon la revendication 8, caractérisé en ce que, les premier et second réseaux optiques du premier motif étant illuminés simultanément par des premier et second faisceaux lumineux, séparables par leur polarisation; il comprend en outre des analyseurs de ces polarisations placés devant les moyens de détection.

12. Système selon l'une quelconque des revendications 1 à 7, caractérisé en ce que, le premier motif étant constitué par deux réseaux optiques identiques (41, 42) dont la première direction $(C'_X)$ du premier réseau est parallèle à un premier axe de coordonnée (X) et la première direction $(C'_Y)$ du deuxième réseau est parallèle à un second axe de coordonnée (Y) perpendiculaire au premier axe de coordonnée, et le second motif étant constitué par un réseau optique unique (C), les moyens optiques comprennent un ensemble de prismes $(P_0)$ permettant de dédoubler l'image du réseau optique unique en deux images secondaires et en ce que ces deux images secondaires sont projetées sur les premier et second réseaux optiques du premier motif de telle sorte que l'alignement du premier motif par rapport au second motif puisse se faire suivant deux aces de coordonnées orthogonaux (X, Y) (fig. 20).

13. Système selon l'une quelconque des revendications 1 à 12 caractérisé en ce qu'il comporte des moyens électroniques de traitement des signaux de sortie des moyens de détection de l'intensité d'une partie prédéterminée des ordres de diffraction suivant la seconde direction $(R_X,$ respectivement $R_Y)$ des premier et second réseaux optiques, et des moyens de commande du déplacement, suivant les axes de coordonnées (X, Y) du premier support de manière à réaliser un alignement automatique suivant ces deux axes, par rétroaction sur les moyens de commande (fig. 13).

14. Photorépéteur utilisant un système optique d'alignement selon l'une quelconque des revendications 1 à 13 pour l'alignement d'une plaquette semiconductrice (4) portant sur sa face supérieure une couche de résine photosensible et sur laquelle est inscrit le premier motif (41, 42), par rapport à un réticule (1) sur lequel est inscrit le second motif (11, 12), ainsi que d'autres motifs (10) à projeter sur la plaquette; photorépéteur caractérisé en ce qu'il comporte un objectif de projection (OP) utilisé alternativement pour la projection de l'image de second motif sur le premier motif pendant des phases d'alignement et pour la projection sur la plaquette en des endroits déterminés (40) de l'image des autres motifs (10) pendant des phases d'exposition (fig. 5 et 6).

15. Photorépéteur selon la revendication 14, caractérisé en ce qu'il comporte en outre un objectif auxiliaire (OA) pour positionner angulairement la plaquette semiconductrice par alignement d'un des réseaux optiques de premier motif par rapport à un troisième motif (100 A) porté par un troisième support (fig. 15).

16. Photorépéteur selon l'une quelconque des revendications 14 à 15 caractérisé en ce qu'il comprend une première source d'énergie lumineuse ayant une première longuer d'onde, activée pendant les phases d'exposition, et une seconde source de lumière ayant une seconde longueur d'onde, activée pendant les phases d'alignement; en ce qu'il comprend, l'objectif étant corrigé pour la première longueur d'onde, des moyens optiques de correction de mise au point compensant l'écart de mise au point et de grandissement dû à l'utilisation de rayonnement; de longueurs d'onde différentes.

17. Photorépéteur utilisant un sytème optique d'alignement selon l'une quelconque des revendications 1 à 13 pour l'alignement du premier motif, $(C'_Y - R'_Y/C'_X - R'_X)$ gravé sur une plaquette semiconductrice (4) portant sur sa face supérieure une couche photosensible, par rapport au second motif (C) constituant une première référence fixe; Photorépéteur caractérisé en ce qu'il comporte un troisième motif $(R_{31}/R_{32})$ formant une seconde référence fixe permettant un alignement initial du second motif par rapport au troisième motif et des moyens optiques comprenant un miroir orientable (600), pour Réaliser cet alignement initial (fig. 20).

18. Photorépéteur selon l'une quelconque des revendications 14 à 17 caractérisé en ce qu'il comprend un dispositif de visualisation (100) du premier motif et de l'image du second motif projeté sur le premier motif; la visualisation étant simultanée à la détection de l'intensité de la partie prédéterminée des ordres de diffraction suivant la seconde direction $(R_X, R_Y)$ des premier et second

**0015173**

réseaux optiques (fig. 5 et 6).

19. Photorépéteur selon la revendication 18, caractérisé en ce que le dispositif de visualisation (100) comporte une caméra de télévision (fig. 6).

**Patentansprüche**

1. Optisches System zur Ausrichtung wenigstens eines ersten Motives, das von einem ersten, beweglichen Träger (4) getragen wird, in bezug auf ein zweites Motiv, das von einem zweiten Träger (1) getragen wird und eine erste, feste Bezugsgröße bildet; wobei das erste und das zweite Motiv jeweils wenigstens ein optisches Hauptgitter (41, 11) umfassen, das durch eine Folge von parallelen Strichen gebildet ist, deren Breite und räumliche Verteilung in einer ersten Richtung (C) durch einen besonderen Verteilungscode bestimmt sind; wobei das optische System eine monochromatische Lichtquelle ($S_0$) enthält; dadurch gekennzeichnet, daß die Striche des ersten Motives ferner periodisch längs einer zweiten Richtung (R) unterbrochen sind, um ein optisches Gitter mit längs dieser Richtung konstanter Teilung zu bilden; und daß vorgesehen sind:

— optische Mittel (CO, OP) zum Konzentrieren der Energie der monochromatischen Lichtquelle auf dem zweiten Motiv und Beleuchten des ersten Motives (41) durch Projektion des Bildes des zweiten Motives (11) auf diesem Motiv mit einer vorbestimmten Vergrößerung, um Beugungsordnungen längs der ersten und der zweiten Richtung (C, R) zu erzeugen;
— und Detektionsmittel (5) zur Detektion der Intensität eines vorbestimmten Teiles ($R_1$) der Beugungsordnungen in der zweiten Richtung (R), wobei die erfaßte Intensität durch ein Maximum geht und die präzise Ausrichtung erhalten ist, wenn die räumliche Korrelation des ersten Motives mit der Projektion des Bildes des zweiten Motives auf dem ersten Motiv maximal ist (Fig. 6).

2. System nach Anspruch 1, dadurch gekennzeichnet, daß der zweite Träger (1) aus einem lichtdurchlässigen Material ist, auf dem das zweite Motiv aufgezeichnet ist, das wenigstens ein optisches Hauptgitter (11) enthält, das aus Strichen gebildet ist, welche abwechselnde Zonen bilden, die durch ihre Transmissionskoeffizienten sich voneinander unterscheiden; und daß der erste Träger (4) aus einem reflektierenden Material ist, auf dem das erste Motiv eingraviert ist, welches wenigstens ein optisches Hauptgitter (41) umfaßt, das durch Striche gebildet ist, die abwechselnde Zonen bilden, welche sich durch ihre Reflexionskoeffizienten voneinander unterscheiden (Fig. 5).

3. System nach den Ansprüchen 1 und 2, dadurch gekennzeichnet, daß der besondere Verteilungscode ein solcher ist, daß die abwechselnden, sich durch ihre Transmissionskoeffizienten voneinander unterscheidenden Zonen des zweiten Motives und die abwechselnden, sich durch ihre Reflexionskoeffizienten voneinander unterscheidenden Zonen des ersten Motives ungleichförmig verteilt sind; wobei die beiden Motive homothetisch sind.

4. System nach Anspruch 3, dadurch gekennzeichnet, daß ferner jedes optische Hauptgitter des ersten Motives durch zwei gleiche Gitter gebildet ist, die mit konstanter Teilung (p') längs der zweiten Richtung (R) verschachtelt und in bezug auf einander in der ersten Richtung (C) versetzt sind, um ein optisches Verbundgitter zu bilden, das zwei diskrete konstante Teilungswerte (p, p') in der zweiten Richtung (R) aufweist, so daß zwei Folgen von Beugungsordnungen erzeugt werden, die räumlich verschieden sind; wobei die Ausrichtung erhalten ist, wenn die erfaßte Intensität eines vorbestimmten Teiles einer der zwei Folgen von Beugungsordnungen in der zweiten Richtung (R) maximal ist (Fig. 9).

5. System nach den Ansprüchen 1 und 2, dadurch gekennzeichnet, daß der besondere Verteilungscode derart ist, daß die abwechselnden, sich durch ihre Transmissionskoeffizienten voneinander unterscheidenden Zonen des zweiten Motives und die abwechselnden, sich durch ihre Reflexionskoeffizienten voneinander unterscheidenden Zonen des ersten Motives ein optisches Hauptgitter mit konstanter Teilung ($p_1$) längs der ersten Richtung (C) bilden und daß auf beiden Seiten des optischen Hauptgitters des ersten Motives in der ersten Richtung (C) ein erstes seitliches optisches Gitter und ein zweites seitliches optisches Gitter vorgesehen sind, die beide eine konstante Teilung in der zweiten Richtung (R) aufweisen; wobei die Teilung ($p_{10}$, $p_{11}$) des ersten und des zweiten seitlichen optischen Gitters voneinander und von der Teilung ($p_1$) des Hauptgitters verschieden sind, so daß längs der zweiten Richtung (R) Beugungsordnungen ($R_{10}$, $R_{11}$) erzeugt werden, die von denjenigen ($R_1$) des Hauptgitters (Fig. 10) verschieden sind.

6. System nach Anspruch 5, dadurch gekennzeichnet, daß erste und zweite zusätzliche Detektionsmittel ($D_{10}$, $D_{11}$) zur Detektion der Intensität eines vorbestimmten Teiles der Beugungsordnungen der seitlichen Gitter vorgesehen sind, die es gestatten, vor der genauen Ausrichtung eine Annäherung vorzunehmen (Fig. 12).

7. System nach einem der Ansprüche 1 bis 6, dadurch gekennzeichnet, daß die optischen Mittel wenigstens eine Konvergenzlinse (CO) enthalten, die die Lichtenergie der monochromatischen Lichtquelle durch das zweite Motiv hindurch konzentriert, und ein Projektionsobjektiv (OP) umfassen, welches das zweite Motiv mit dem ersten Motiv optisch konjugiert; und daß die gebeugten Strahlen, die sich durch die Projektion ergeben, das Projektionsobjektiv auf ihrem Rückweg durchqueren, um in

11

dem Bild ($p'_F$) der Fourier-Ebene ($p_F$) erfaßt zu werden (Fig. 6).

8. System nach einem der Ansprüche 1 bis 7, dadurch gekennzeichnet, daß das erste und das zweite Motiv jeweils durch zwei optische Gitter (41, 42; 11, 12) gebildet sind und daß die erste Richtung ($C_X$) des ersten Gitters parallel zu einer ersten Koordinatenachse (X) und die erste Richtung ($C_Y$) des zweiten Gitters parallel zu einer zweiten Koordinatenachse (Y) ist, die zu der ersten Koordinatenachse senkrecht ist, so daß die Ausrichtung des ersten Motives längs zwei senkrechten Koordinatenachsen erfolgen kann (Fig. 5).

9. System nach Anspruch 8, dadurch gekennzeichnet, daß es ferner zwei Verschlüsse umfaßt, so daß das erste und das zweite optische Gitter des ersten Motives sequentiell beleuchtet werden; wobei die Ausrichtung in den beiden Koordinatenachsen (X, Y) hergestellt wird, indem synchron mit der Beleuchtung des ersten und des zweiten optischen Gitters ein vorbestimmter Teil der Beugungsordnungen in der zweiten Richtung ($R_X$ bzw. $R_Y$) des ersten und des zweiten optischen Gitters erfaßt wird (Fig. 5).

10. System nach Anspruch 8, dadurch gekennzeichnet, daß, wenn das erste und das zweite optische Gitter des ersten Motives gleichzeitig durch ein erstes und ein zweites Lichtbündel beleuchtet werden, deren erstes mit einer ersten Frequenz ($f_1$) und deren zweites mit einer zweiten Frequenz ($f_2$) moduliert ist, ferner elektronische Mittel zum Unterscheiden zwischen den beiden Frequenzen vorgesehen sind; wobei diese beiden Frequenzen der Ausrichtung längs jeweils einer der beiden Koordinatenachsen (X, Y) zugeordnet sind (Fig. 13).

11. System nach Anspruch 8, dadurch gekennzeichnet, daß, wenn das erste und das zweite optische Gitter des ersten Motives gleichzeitig durch ein erstes und ein zweites Lichtbündel beleuchtet werden, die durch ihre Polarisation voneinander getrennt werden können, das System ferner Analysatoren zur Feststellung dieser Polarisationen enthält, die vor den Detektionsmitteln angeordnet sind.

12. System nach einem der Ansprüche 1 bis 7, dadurch gekennzeichnet, daß, wenn das erste Motiv durch zwei einander gleiche optische Gitter (41, 42) gebildet ist, wobei die erste Richtung ($C'_X$) des ersten Gitters parallel zu einer ersten Koordinatenachse (X) und die erste Richtung ($C'_Y$) des zweiten Gitters parallel zu einer zweiten Koordinatenachse (Y) ist, die parallel zu der ersten Koordinatenachse ist, und wenn das zweite Motiv durch ein einziges optisches Gitter (C) gebildet ist, die optischen Mittel eine Gruppe von Prismen ($P_0$) enthalten, die es ermöglichen, das Bild des einzigen optischen Gitters in zwei sekundäre Bilder zu verdoppeln, und daß die beiden sekundären Bilder auf das erste und auf das zweite optische Gitter des ersten Motives projiziert werden, so daß die Ausrichtung des ersten Motives in bezug auf das zweite Motiv längs zwei zueinander senkrechten Koordinatenachsen (X, Y) erfolgen kann (Fig. 20).

13. System nach einem der Ansprüche 1 bis 12, dadurch gekennzeichnet, daß es elektronische Mittel zur Verarbeitung der Ausgangssignale der Detektionsmittel zur Erfassung der Intensität eines vorbestimmten Teiles der Beugungsordnungen in der zweiten Richtung ($R_X$ bzw. $R_Y$) des ersten und des zweiten optischen Gitters und Steuermittel für die Verschiebung des ersten Trägers längs den Koordinatenachsen (X, Y) derart, daß eine automatische Ausrichtung längs den beiden Achsen durch Rückkopplung auf die Steuermittel erreicht wird, umfaßt (Fig. 13).

14. Photoempfänger, der ein optisches Ausrichtungssystem nach einem der Ansprüche 1 bis 13 anwendet, zur Ausrichtung eines Halbleiterplättchens (4), das auf seiner Oberseite eine photoempfindliche Harzschicht trägt und auf dem das erste Motiv (41, 42) aufgezeichnet ist, in bezug auf ein Gitter (1), auf dem das zweite Motiv (11, 12) sowie weitere Motive (10), die auf das Plättchen projiziert werden sollen, aufgezeichnet sind; wobei der Photoempfänger dadurch gekennzeichnet ist, daß er ein Projektionsobjektiv (OP) umfaßt, das abwechselnd zum Projizieren des zweiten Motives auf das erste Motiv während den Ausrichtphasen und zur Projektion des Bildes des anderen Motives (10) auf dem Plättchen an bestimmten Stellen (40) während der Belichtungsphasen verwendet wird (Fig. 5 und 6).

15. Photoempfänger nach Anspruch 14, dadurch gekennzeichnet, daß er ferner ein Hilfsobjektiv (OA) umfaßt, um die Winkelpositionierung des Halbleiterplättchens durch Ausrichtung eines der optischen Gitter des ersten Motives in bezug auf ein drittes Motiv (100A) vorzunehmen, das ein dritter Träger trägt (Fig. 15).

16. Photoempfänger nach einem der Ansprüche 14 und 15, dadurch gekennzeichnet, daß er eine erste Lichtquelle mit einer ersten Wellenlänge enthält, die während der Belichtungsphasen aktiviert wird, und eine zweite Lichtquelle mit einer zweiten Wellenlänge umfaßt, die während der Ausrichtphasen aktiviert wird; und daß er, wenn das Objektiv für die erste Wellenlänge korrigiert ist, optische Scharfeinstellungs-Korrekturmittel umfaßt, die den Scharfeinstellungs- und Vergrößerungsfehler kompensieren, der auf der Anwendung von Strahlungen verschiedener Wellenlängen beruht.

17. Photoempfänger, bei dem ein optisches Ausrichtsystem nach einem der Ansprüche 1 bis 13 verwendet wird, um ein erstes Motiv ($C'_Y - R'_Y/C'_X - R'_X$), das auf einem Halbleiterplättchen (4) eingraviert ist, welches auf seiner Oberseite eine photoempfindliche Schicht trägt, in bezug auf ein zweites Motiv (C) auszurichten, das eine erste, feste Bezugsgröße bildet; wobei der Photoempfänger dadurch gekennzeichnet, daß er ein drittes Motiv ($R_{31}/R_{32}$) umfaßt, das eine zweite, feste Bezugsgröße bildet, die eine anfängliche Ausrichtung des zweiten Motives in bezug auf das dritte Motiv gestattet, und optische Mittel aufweist, die einen Spiegel (600) umfassen, der so orientiert werden kann, daß er diese Anfangsausrichtung herstellt (Fig. 20).

18. Photoempfänger nach einem der Ansprüche 14 bis 17, dadurch gekennzeichnet, daß er eine Vorrichtung (100) zur sichtbaren Darstellung des ersten Motives und des auf das erste Motiv projizierten Bildes des zweiten Motives umfaßt; wobei die sichtbare Darstellung gleichzeitig mit der Erfassung der Intensität des vorbestimmten Teiles der Beugungsordnungen in der zweiten Richtung ($R_X$, $R_Y$) des ersten und des zweiten optischen Gitters erfolgt (Fig. 5 und 6).

19. Photoempfänger nach Anspruch 18, dadurch gekennzeichnet, daß die Vorrichtung zur sichtbaren Darstellung (100) eine Fernsehkamera umfaßt (Fig. 6).

## Claims

1. Optic system for the alignment of at least a first pattern carried by a first movable support (4) with respect to a second pattern carried by a second support (1), forming a first fixed reference; the first and second pattern each comprising at least one main optic grating (41, 11) formed by a sequence of parallel lines the width and spacial distribution of which along a first direction (C) are determined by a particular distribution code; the optic system comprising a monochromatic light energy source ($S_0$); the system being further characterized in that the lines of the first pattern are periodically interrupted along a second direction (R) to form an optic grating having constant pitch along said direction; and by the provision of:

— optic means (CO, OP) for concentrating the energy of said monochromatic light energy source on the second pattern and illuminating the first pattern (41) by projection of the image of the second pattern (11) on said pattern with a predetermined magnification to produce diffraction orders along said first and second directions (C, R);

— and means (5) for detecting the intensity of a predetermined part (R1) of the diffraction orders along the second direction (R), the detected intensity passing through a maximum and the precise alignment being obtained when the spacial correlation of the first pattern and of the projection of the image of the second pattern on the first pattern is maximum (Fig. 5 and 6).

2. System in accordance with claim 1, characterized in that the second support (1) is of transparent material on which the second pattern is traced, comprising at least one main optic grating (11) formed by lines defining alternating zones differing by their transmission coefficients; and in that the first support (4) is of a reflecting material on which the first pattern is traced, comprising at least one main optic grating (41) formed by lines defining alternating zones differing by their reflection coefficients (Fig. 5).

3. System in accordance with claims 1 and 2, characterized in that the particular distribution code is such that the alternating zones differing by their transmission coefficients of the second pattern and the alternating zones differing by their reflection coefficients of the first pattern are distributed in non-uniform manner; the two patterns remaining homothetic.

4. System in accordance with claim 3, characterized in that, in addition, each main optic grating of the first pattern is formed by two identical gratings interleaved at constant pitch (p') along the second direction (R) and shifted one with respect to the other along the first direction (C) to form a composite optic grating having two discrete values of constant pitch along the second direction (R), in a manner to produce two sequences of diffraction orders which are spacially distinct; the alignment being obtained when the detected intensity of a predetermined portion of one or the other of the two sequences of diffraction orders along the second direction (R) is maximum (Fig. 9).

5. System in accordance with claims 1 and 2, characterized in that the particular distribution code is such that the alternating zones differing by their transmission coefficients of the second pattern and the alternating zones differing by their reflection coefficients of the first pattern define a main optic grating having constant pitch ($p_1$) along the first direction (C), and in that, on both sides of the main optic grating of the first pattern and along the first direction (C) a first lateral optic grating and a second lateral optic grating having both constant pitch along the second direction (R) are provided; the pitches ($p_{10}$, $p_{11}$) of the first and second lateral optic gratings being different from each other and different from the pitch ($p_1$) of the main grating, in a manner to produce diffraction orders ($R_{10}$, $R_{11}$) distinct from those ($R_1$) of the main grating, along the second direction (R) (Fig. 10).

6. System in accordance with claim 5, characterized in that first and second additional means ($D_{10}$, $D_{11}$) for detecting the intensity of a predetermined part of the diffraction orders of the lateral gratings are provided, allowing to perform an approach prior to precise alignment (Fig. 12).

7. System in accordance with any of claims 1 to 6, characterized in that the optic means comprise at least one converging lens (CO) concentrating the light energy of the monochromatic light source through the second pattern and a projection objective (OP) optically conjugating the second pattern and the first pattern; and in that the diffracted rays resulting from the projection travel back through the projection objective to be detected in the image ($p'_F$) of the Fourier plane ($p_F$) (Fig. 6).

8. System in accordance with any of claims 1 to 7, characterized in that the first and second patterns are each formed by two optic gratings (41, 42; 11, 12) and in that the first direction ($C_X$) of the first grating is parallel to a first coordinate axis (X) and the first direction ($C_Y$) of the second grating is parallel to a second coordinate axis (Y) perpendicular to the first coordinate axis, so that the alignment of the first pattern may be produced along two perpendicular coordinate axes (Fig. 5).

9. System in accordance with claim 8, characterized in that it further comprises two shutters so that the first and second optic gratings of the first pattern are sequentially illuminated; the alignment along the two coordinate axes (X, Y) being obtained by detecting, in synchronism with the illumination of the first and second optic gratings, a predetermined part of the diffraction orders along the second direction ($R_X$ and $R_Y$, respectively) of the first and second optic gratings (Fig. 5).

10. System in accordance with claim 8, characterized in that, the first and second optic gratings of the first pattern being simultaneously illuminated by first and second light beams modulated at a first frequency ($f_1$) and at a second frequency ($f_2$), respectively, it further comprises electronic means adapted for discrimination of these two frequencies; each of these two frequencies being associated with the alignment along one of said two coordinate axes (X, Y) (Fig.13).

11. System in accordance with claim 8, characterized in that, the first and second optic gratings of the first pattern being simultaneously illuminated by first and second light beams that may be separated by their polarizations; it further comprises analyzers placed in front of the detecting means for analyzing these polarizations.

12. System in accordance with any of claims 1 to 7, characterized in that, the first pattern being formed by two identical optic gratings (41, 42) wherein the first direction ($C'_X$) of the first grating is parallel to a first coordinate axis (X) and the second direction ($C'_Y$) of the first grating is parallel to a second coordinate axis (Y) perpendicular to the first coordinate axis, and the second pattern being formed by a single optic grating (C), the optic means comprise a set of prisms ($P_0$) allowing to duplicate the image of the single optic grating into two secondary images, and in that these two secondary images are projected on the first and second optic gratings of the first pattern, so that the alignment of the first pattern with respect to the second pattern may be produced along two perpendicular coordinate axes (X, Y) (Fig. 20).

13. System in accordance with any of claims 1 to 12, characterized in that it comprises electronic means for processing the output signals of the means for detection of the intensity of a predetermined part of the diffraction orders along the second direction ($R_X$ and $R_Y$, respectively) of the first and second optic gratings, and means for controlling the displacement of the first support along the coordinate axis (X, Y), in a manner to obtain an automatic alignment along these two axes, by feedback to the control means (Fig. 13).

14. Photo-receptor using an optic alignment system according to any of claims 1 to 13 for the alignment of a semiconductor chip (4) carrying a photosensitive resin layer on its upper face and on which the first pattern (41, 42) is traced, with respect to a grating (1) on which the second pattern (11, 12) is traced, as well as other patterns (10) to be projected on the chip; the photo-receptor being characterized in that it comprises a projection objective (OP) used in alternating manner for the projection of the second pattern onto the first pattern during alignment stages and for the projection of the image of the other patterns (10) onto the chip at predetermined locations (40) during the exposure stages (Figs. 5 and 6).

15. Photo-receptor in accordance with claim 14, characterized in that it further comprises an auxiliary objective (OA) for angular positioning of the semiconductor chip by alignment of one of the optic gratings of the first pattern with respect to a third pattern (100A) carried by a third support (Fig. 15).

16. Photo-receptor in accordance with any of claims 14 and 15, characterized in that it comprises a first light energy source having a first wave length and activated during the exposure stages, and a second light source having a second wave length and activated during the alignment stages; and in that, the objective being corrected for the first wave length, it comprises optic focus correction menas compensating for the focus and magnification shift due to the use of radiation of different wawe lengths.

17. Photo-receptor using an optic alignment system in accordance with any of claims 1 to 13 for the alignment of a first pattern ($C'_Y - R'_Y/C'_X - R'_X$) traced on a first semiconductor chip (4) carrying a photosensitive layer on its upper face, with respect to the second pattern (C) forming a fixed first reference; the photo-receptor characterized in that it comprises a third pattern ($R_{31}/R_{32}$) forming a second fixed reference allowing an initial alignment of the second pattern with respect to the third pattern and optic means comprising a mirror (600) adapted to be oriented to produce said initial alignment (Fig. 20).

18. Photo-receptor in accordance with any of claims 14 to 17, characterized in that it comprises a visualization device (100) of the first pattern and of the image of the second pattern projected onto the first pattern; the visualization being simultaneous with the detection of the intensity of the predetermined part of the diffraction orders along the second direction ($R_X$, $R_Y$) of the first and second optic gratings (Figs. 5 and 6).

19. Photo-receptor in accordance with claim 18, characterized in that the visualization device (100) comprises a television camera (Fig. 6).

0015173

Fig. 2

Fig. 3

Fig. 4

Fig. 5

0 015 173

Fig. 6

Fig. 7

FIG. 8

FIG. 9

FIG. 10

Fig. 11

Fig. 12

Fig. 14

Fig. 13

$$\fbox{F ι ⊏}.15$$

Fig.16

Fig.17

FIG.18

FIG.19

FIG. 20